# EUROPEAN PATENT APPLICATION

(11) **EP 1 857 164 A1**
(43) Date of publication of application: **21.11.2007**
(21) Application number: 06714086.3
(22) Date of filing: 20.02.2006
(51) Int. Cl.: B01D 53/14, B01D 53/26, B01D 53/28

(54) **ADSORPTION FILM AND ORGANIC EL DEVICE**

(30) Priority: 21.02.2005 JP 2005044149
(71) Applicant: Kyodo Printing Co., Ltd., Tokyo 112-8501 (JP)
(72) Inventor: KOIZUMI, Shinichi, chome, Bunkyo-ku, Tokyo, 1120002 (JP); OGAWA, Tatsuya, chome, Bunkyo-ku, Tokyo, 1120002 (JP); NAKAGAWA, Junpei, chome, Bunkyo-ku, Tokyo, 1120002 (JP); CHIBA, Eisuke, chome, Bunkyo-ku, Tokyo, 1120002 (JP)
(74) Representative: Gervasi, Gemma
(86) International application number: PCT/JP2006/302945
(87) International publication number: WO 2006/088179

(57) **Abstract**

The object of the present invention is to provide the adsorbent film and the organic EL device comprising the adsorbent film, wherein the water remained within the organic EL device can rapidly adsorb to hold without detaching, the water derived from the circumference can adsorb in a long period, gases as remained or generated in the device, including acidic gases, can adsorb, the life span of the organic EL element can be extended, the workability thereof is superior, it has the sufficient ability of drying, and the moisture adsorbent function can be obtained even in the normal temperature and high-temperature environments. According to the present invention, the adsorbent film and organic EL device comprising the adsorbent film are **characterized in that** the adsorbent film comprises the resin and the desiccant, it has at least two of moisture adsorbent layers, at least one of the layers contains the chemically-adsorptive desiccant, and the other contains the physically-adsorptive desiccant.

## Description

### Technical field of the invention

The present invention relates to an adsorbent film adsorbing a water and a predetermined gas component, especially, an organic EL device comprising the adsorbent film within the organic EL device.

### Prior Art

Currently, in the organic EL device used in the several types of displays and the light emitting devices, there is a problem that portions which cannot emit light is occurred so that the light emitting property is decreased. The causes of the problem include oxidation and denaturalization of members and components composed of the organic EL device including electrodes and light emitting material for the organic EL by the vapor and oxygen transmitting from the environment, and detachment of the light emitting material from the electrode.

As means for solving such a problem, in order to extend the life span of the light emitting layer, encapsulation of the desiccant which absorbs the water and the adsorbent which adsorbs the oxygen within thereof has been utilized (see Patent Documents 1 and 2).

However, in the case of using such a device in a high-temperature environment including inside of the automobile in summer, it has been apprehended that the light emitting layer is deteriorated due to the water as desorbed from the physically-adsorptive desiccant which physically adsorbs the water, including zeolite and silica gel. In addition, it is known that the moisture adsorbent property of the chemically-adsorptive desiccant including alkali metal oxides which chemically adsorbs the water is decreased in the normal temperature environment, while the moisture adsorbent property of the chemically-adsorptive desiccant is high in the high-temperature environment.

In addition, there is a problem that gases originated from the materials which encapsulate in the device including the adhesive agent and the bonding adhesive agent deteriorate the light emitting layer. The problem can not be completely eliminated, although materials which do not generate such a gas as much as possible have been used.
Patent-related Reference 1: Japanese Patent Application Publication No. 2001-277395
Patent-related Reference 2: Japanese Patent Application Publication No. 2002-280166

### Disclosure of the invention

### Problem to be solved by the invention

The present invention which is made in view of the above-mentioned problem is to provide an adsorbent film wherein the adsorbent film can rapidly absorb and hold the water without detaching thereof, can absorb the water from the environment in the prolonged time, and can also actively absorb the gases remained within or generated from the device such that the life span of the light emitting property of the organic EL element is extended. The present invention is also to provide an organic EL device comprising the adsorbent film within the organic EL device.

The present invention is also to provide an adsorbent film and an organic EL device comprising the adsorbent film which has a good workability and a sufficient desiccative property, and creating a superior moisture adsorbent function even in the high-temperature environment.

### Means for solving the problem

According to the present invention, the adsorbent film is constituted from:
a first moisture adsorbent layer containing a chemically-adsorptive desiccant; and
a second moisture adsorbent layer containing a physically-adsorptive desiccant.

In addition, the organic EL device according to the present invention comprises the adsorbent film as mentioned above.

### Effect of the invention

According to the present invention, a method for adsorbing the water within the organic EL device with rapid adsorption in early state and gradual adsorption in a prolonged time can be established by means of using two or more of desiccants among the physically-adsorptive desiccant and chemically-adsorptive desiccant. In addition, the water can be rapidly and strongly adsorbed by the physically-adsorptive desiccant and such a water can be held therein by transferring the water into the chemically-adsorptive desiccant and without detaching therefrom. Therefore, the life span of the light emitting property for the organic EL device can be extended.

Further, gases remained within or generated in the organic EL device, especially acidic gases, can be adsorbed and/or removed by the alkali matter denatured from the chemically-adsorptive desiccant by moisture adsorption. Therefore, the life span can be further extended.

### Brief Explanation of the Drawings

Figure 1 is a schematic cross-sectional view showing an example of the adsorbent film according to the present invention.
Figure 2 is a schematic cross-sectional view showing an example of the organic EL device comprising the adsorbent film according to the present invention.

### Explanation of the Notations

- 100: adsorbent film
- 110: moisture adsorbent layer
- 112: first moisture adsorbent layer
- 114: second moisture adsorbent layer
- 120: adhesion layer
- 130: adsorptive velocity controlling layer
- 140: coherent layer
- 150: biaxially-stretched film
- 200: organic EL device
- 210: substrate
- 220: organic EL element
- 230: vessel

### Best modes of embodying the invention

Reference will be made with regard to aspects of the present invention.

The present invention focuses attention on the adsorbing velocity of the water and the adsorbing property thereof. The present invention is characterized in that both of a desiccant which physically adsorbs the water with high adsorbing velocity (hereinafter, referred to as "physically-adsorptive desiccant") and a desiccant which chemically adsorbs the water and does not release the water once adsorbed (hereinafter, referred to as "chemically-adsorptive desiccant") are used, thereby synergistically improving the effect.

In addition, with regard to the problem in the art that the water is desorbed from the physically-adsorptive desiccant including zeolite and silica gel, the water can be held in any environments including high-temperature environment without desorbing the water, since both of the physically-adsorptive desiccant and chemically-adsorptive desiccant are used such that the water adsorbed in the physically-adsorptive desiccant is gradually transferred to the chemically-adsorptive desiccant.

Further, the gases as remained within or generated from the organic EL device, especially the acid gas, can be adsorbed and/or removed by means of denaturing the chemically-adsorptive desiccant into an alkali matter by adsorbing the moisture, thereby extending the life span of the light emitting property.

### (The physically-adsorptive desiccant)

In the present invention, examples of the physically-adsorptive desiccant include zeolite, silica gel, active alumina and activated charcoal. In generally, the physically-adsorptive desiccant can rapidly adsorb the water, since the adsorbing velocity is high. Especially, the physically-adsorptive desiccant is preferably zeolite.

Reference will be made with regard to the zeolite which is an example of the physically-adsorptive desiccant. The zeolite is composed of oxides of aluminum and silica, and has a structure that alkali metal, alkali earth metal, and water molecule are inserted in the three-dimensional network structure. The zeolite can be derived from nature and be industrially manufactured. Molecular sieve, which representative of zeolite, is a porous particulate material which is used in separating materials based on the difference of the molecular size of substances. The molecular sieve has uniformly-sized pores, and adsorbs a small molecule which is entered in the cavity of the pore to act as a type of sieves. In the present invention, the bore diameter of the molecular sieve is preferably in the range of 0.3 nm to 1 nm, in the case of the molecular sieve used as the physically-adsorptive desiccant. In general, the molecular sieves having pore sizes of 0.3 nm, 0.4 nm, 0.5 nm and 1 nm are referred to as molecular sieve 3A, molecular sieve 4A, molecular sieve 5A and molecular sieve 13X, respectively. In the embodiments of the present invention, the molecular sieve 3A or molecular sieve 4A is used as preferable desiccants. In addition, it is used the molecular sieve having about 10 µm of an average diameter.

It should be noted that the adsorptive property of the molecular sieve depends on its pore size. Therefore, the molecular sieve in the form of powder can be further ground to substantially enlarge the surface area of the molecular sieve and increase the number of the pores.

### (The chemically-adsorptive desiccant)

In the present invention, examples of the chemically-adsorptive desiccant include calcium oxide, calcium chloride, magnesium sulfate, barium oxide, phosphorus pentaoxide, potassium hydroxide, sodium hydroxide, potassium bromide, calcium bromide, copper sulfate, zinc chloride, calcium sulfate and magnesium oxide. Especially, calcium oxide is preferable due to the high handling. In general, the physically-adsorptive desiccant gradually adsorbs substances and the adsorbed substances are not detached therefrom once adsorbed, although the water-adsorbing velocity of the chemically-adsorptive desiccant is low in comparison with the physically-adsorptive desiccant. Therefore, the water is not desorbed from the chemically-adsorptive desiccant which is used within the organic EL device even in the case of the high-temperature environment, thereby minimizing the degradation of the light emitting layer.

Further, there are several materials belonging to the chemically-adsorptive desiccant which denatures into an alkali material by adsorbing the water and can adsorb acidic materials. For example, calcium oxide is changed into the calcium hydroxide (the alkali material) by reacting the water such that the acidic materials including formaldehyde are reacted and/or naturalized with the alkali material, thereby being capable of removing the acidic material.

Further, hydrophobic zeolite can be added as adsorbing agents, thereby being capable of efficiently adsorbing odor components.

### (The adsorbent film)

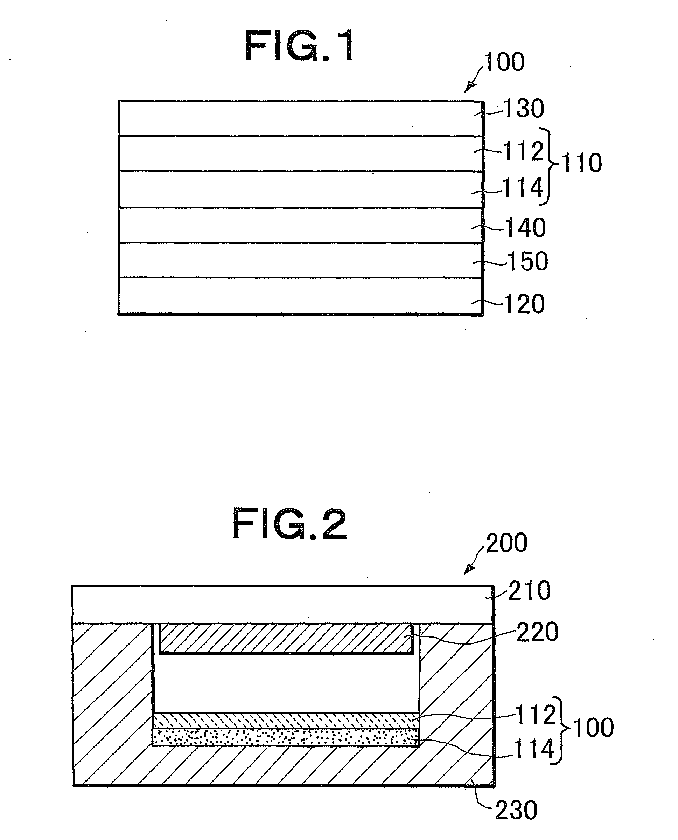

Next, reference will be made with regard to the adsorbent film according to the present invention. Figure 1 is a schematic cross-sectional view showing an example of the adsorbent film according to the present invention. The adsorbent film according to the present invention is constituted from a first moisture adsorbent layer 112 containing the above-mentioned chemically-adsorptive desiccant, and a second moisture adsorbent layer 114 containing the above-mentioned physically-adsorptive desiccant. The adsorbent film according to the present invention is preferably constituted from three layers having two types of materials or three layers having three types of materials. Preferably, among the three layers, two layers are a moisture adsorbent layer 110 which contains a resin for mixing the adsorbent agent and one layer located on the bottom side is a coherent layer 140 for adhering it to members including the substrate. Further, the adsorbent film according to the present invention may further comprise an adsorptive velocity controlling layer 130. The adsorptive velocity controlling layer 130 is preferably provided on the upper side of the adsorbent film as a most upper layer. The adsorptive velocity controlling layer 130 may not be necessary, since it is for controlling the velocity of the moisture adsorbent.

The adsorbent film according to the present invention is preferably constituted such that in the moisture adsorbent layer 110, the first moisture adsorbent layer 112 containing the chemically-adsorptive desiccant is located on the outer layer side of the film and that the second moisture adsorbent layer 114 containing the physically-adsorptive desiccant is located on the inner layer side of the film. In addition, it is preferable that the first moisture adsorbent layer 112 is only constituted from calcium oxide, and the second moisture adsorbent layer 114 is only constituted from zeolite. It is further preferable that in the moisture adsorbent layer 110, the first moisture adsorbent layer 112 only constituted from calcium oxide is located in the outer layer side of the film and the second moisture adsorbent layer 114 only constituted from zeolite is located in the inner layer side of the film. Both of the outer layer and the inner layer may be constituted not only from the physically-adsorptive desiccant and chemically-adsorptive desiccant but also from the combination of the physically-adsorptive desiccant and chemically-adsorptive desiccant. The ratio of the physically-adsorptive desiccant and chemically-adsorptive desiccant in the layers is preferably in the range of physically-adsorptive desiccant : chemically-adsorptive desiccant=99:1~1:99 (weight part). The ratio of the physically-adsorptive desiccant and chemically-adsorptive desiccant may be appropriately changed in accordance with the use environment of the adsorbent film. For example, the ratio is preferably in the range of the physically-adsorptive desiccant : chemically-adsorptive desiccant=90:10-60:40, if the water need to be rapidly adsorbed in the low-temperature environment. This is because the adsorbing velocity of the physically-adsorptive desiccant is higher than that of the chemically-adsorptive desiccant. That is, the above-mentioned ratio is preferable if the high adsorbing velocity of the physically-adsorptive desiccant is desired. On the other hand, it is preferable that the ratio of the physically-adsorptive desiccant and chemically-adsorptive desiccant is in the range of 5:95~40:60, if the large amount of water need to be adsorbed. This is because the capacity of the adsorbing amount of the chemically-adsorptive desiccant is higher than that of the physically-adsorptive desiccant.

Reference will be made with regard to the situation of using the molecular sieve which is one of the physically-adsorptive desiccant and calcium oxide which is one of the chemically-adsorptive desiccant. The adsorbing velocity of the physically-adsorptive desiccant including the molecular sieve is primarily higher than that of the chemically-adsorptive desiccant. Therefore, the water as adsorbed in the molecular sieve can be held in the film even if the water will transfer to calcium oxide in the high-temperature environment without desorbing the water from the film. On the other hand, the molecular sieve can adsorb 20 weight % or less of the water by the weight of the molecular sieve while calcium oxide can adsorb 30 weight % or less of the water by the weight of calcium oxide. Therefore, maximum amount of the water adsorption of calcium oxide is larger than that of the molecular sieve. In the present invention, the physically-adsorptive desiccant and chemically-adsorptive desiccant can be appropriately used in accordance with the adsorbing property thereof.

In the moisture adsorbent layer of the adsorbent film according to the present invention, the content of the physically-adsorptive desiccant and chemically-adsorptive desiccant is preferably in the range of 40 to 80 weight % by weight of the second moisture adsorbent layer and first moisture adsorbent layer, respectively. In the case of less than 40 weight % of the content, it is difficult to obtain the sufficient drying performance in the molded product. In the case of more than 80 weight % of the content, it is difficult to mold the product.

Resin materials for manufacturing the moisture adsorbent layer are preferably a resin that has high melt flow rate (hereinafter, referred to as MFR) and low melt point and superior to the low-temperature draw down. It is possible that a predetermined flowing characteristic can be maintained in the resin having high MFR even in the case of decreasing MFR by adding the desiccant. In addition, the extrusion at low temperature can be performed by softening the resin at the low temperature, in the case of the resin having low melt point, thereby preventing the chance of the foam formation. In case of using resin having the superior low-temperature draw down, the extrusion molding with the extrusion molding machine can be easily performed, even in the case of addition of the desiccant.

In the above-mentioned point of view, examples of the resin of the moisture adsorbent layer include LDPE (low-density polyethylene), LLDPE (linear low-density polyethylene), PP (polypropylene), several types of copolymer including ionomer (e.g. salt of ethyleneacrylate copolymer), EAA (ethyleneacrylate copolymer), EMAA (ethylenemethacrylate copolymer), EVA (ethylenevinylacetate copolymer), EEA (ethyleneethyleneacrylate copolymer), EMA (ethylenemethylacrylate copolymer) and EMMA (ethylenemethylmethacrylate copolymer).

The adsorbent film according to the present invention is preferably formed of the resin and the desiccant by extrusion molding including inflation molding, T-die method and coextrusion method, or injection molding. Especially, it is preferably a multilayer film formed by the inflation molding. It should be noted that the inflation molding is a method for manufacturing the multilayer film comprising the steps of extruding the melted resin into the film matter with a plurality of extruders, and pumping up it with supplying the compressed air thereinto.

According to the invention, the thickness of the moisture adsorbent layer is preferably in the range of 20 to 200 µm. The thickness of the first moisture adsorbent layer comprising the chemically-adsorptive desiccant is preferably in the range of 10 to 190µm and that of the second moisture adsorbent layer 114 comprising the physically-adsorptive desiccant is preferably in the range of 10 to 190 µm. In the present invention, as described above, these thicknesses of the first and second moisture adsorbent layers may be appropriately adjusted in accordance with the use environment, since the adsorbent properties will be changed due to the active energy thereof. For example, in the case of increasing the adsorbent amount of the water under the high-temperature, the thickness of the first moisture adsorbent layer comprising the chemically-adsorptive desiccant may be increased. In addition, in the case of increasing the adsorbent amount of the water under from the low temperature through the normal temperature or of adsorbing any components other than the water, the thickness of the second moisture adsorbent layer comprising the physically-adsorptive desiccant may be increased.

The organic EL device may comprise the coherent layer for improving the coherence of the adhesive agent except of the moisture adsorbent layer, due to the treatment of the adhesive agent in the adsorbent film of the organic EL device. In the case of using the adsorbent film within the organic EL device, the heat resistance to the adsorbent film will be required, since the heat treatment will be performed in the manufacturing process. A wrinkle may be occurred in the film by the heat treatment, if the resin having low resistance to the heat will be used in the manufacturing of the adsorbent film. In the case, the design for the film will be necessary to consider the increase of the thickness accompanied by the occurrence of the wrinkle in the film. If the wrinkle will not be occurred in the film after the treatment of the heat, it is possible to increase the thickness of the moisture adsorbent layer in increase in the thickness due to the wrinkle, thereby being capable of further improving the moisture adsorbent property.

Resins for manufacturing the coherent layer and the adsorptive velocity controlling layer is preferably identical to each other in view of easily manufacturing thereof, although the resins may be or not be identical to each other. Examples of the resin include LLDPE (linear low-density polyethylene), LDPE (low-density polyethylene), HDPE (high-density polyethylene), OPP (drawn polypropylene film), CPP (non-drawn polypropylene film) and PAN (polyacrylonitrile). Especially, LLDPE is preferable due to the general versatility.

The adsorptive velocity controlling layer is preferably formed from the single resin material. The thickness of the layer is preferably in the range 10 to 30 µm. Normally, it is manufactured by the inflation method along with the manufacturing of the moisture adsorbent layer.

The adsorbent film according to the present invention may comprise a biaxially-stretched film in consideration of the handling at the manufacturing and the work operations. Normally, in the case of manufacturing the adsorbent film according to the present invention by the inflation method, the materials constituting of the adsorbent film has less drappability, and the handling of such an adsorbent film may be difficult. In the case of providing the biaxially-stretched film 150 therein, the appropriate drappability can be obtained, thereby improving the handling. The location of the biaxially-stretched film is not limited, although the biaxially-stretched film 150 is provided in the lower side of the coherent layer 140 (that is, the near side of the organic EL device) as shown in Figure 1. The thickness of the biaxially-stretched film is preferably in the range of 7 to 50 µm due to the processability. Examples of materials for the biaxially-stretched film include PET (polyethylene terephtalate). The adhesion layer 120 may be provided between the adsorbent film and the organic EL device in the case of providing the biaxially-stretched film in the near side of the organic EL device as shown in Figure 1. The constitution of the adhesion layer 120 may be selected as the same constitution of the coherent layer 140 as mentioned above.

### (The organic EL device)

Next, reference will be made with regard to the organic EL device according to the present invention. Figure 2 is a schematic cross-sectional view showing an example of the organic EL device comprising the adsorbent film according to the present invention.

According to Figure 2, the organic EL device 200 according to the present invention comprises a organic EL element 220 formed on a substrate 210, a vessel 230 disposed on the substrate 210 and physically blocking from the environment, and an adsorbent film 100 formed on the vessel 230. The adsorbent film 100 is the above-mentioned adsorbent film according to the present invention. According to Figure 2, the adsorbent film is disposed in the back side of the organic EL element 220 formed on the substrate 210, and is fixed to the wall portion of the vessel 230 (that is, the wall portion of the organic EL element 220) through the adhesive agent.

When the adsorbent film 100 comprises the coherent layer or adhesion layer, the vessel 230 and adsorbent film 100 may be adhered through such layers. In addition, when the adsorbent film 100 comprises such layers, the adsorbent film 100 may be adhered through the coated adhesive agent on the vessel 230.

Explanation will be made with regard to the moisture adsorbent mechanism of the adsorbent film in the organic EL device according to the present invention, in reference to the example shown in Figure 2. The moisture to be adsorbed is firstly adsorbed in the second moisture adsorbent layer 114 comprising the physically-adsorptive desiccant, which easily adsorb it, on the inner side, upon easily passing through the first moisture adsorbent layer 112 comprising the chemically-adsorptive desiccant on the outer side, since the active energy of the water is relatively high. It is because the physically-adsorptive desiccant having the high moisture activity easily adsorbs the water, since the moisture adsorbent activity of the chemically-adsorptive desiccant is low from in the low-temperature environment through in the normal temperature environment. On the other hand, in the high temperature environment, the moisture adsorbent activity of the chemically-adsorptive desiccant will increase than that of physically-adsorptive desiccant. Therefore, the moisture detached from the second moisture adsorbent layer 114 comprising the physically-adsorptive desiccant will be adhered in the first moisture adsorbent layer 112 comprising the chemically-adsorptive desiccant adjacent to the second moisture adsorbent layer 114. As such, the first moisture adsorbent layer 112 comprising the chemically-adsorptive desiccant on the outer side has a role for preventing incoming and outgoing the water detached from the second moisture adsorbent layer 114 comprising the physically-adsorptive desiccant.

### Embodiment

Hereinafter, detailed reference will be made with regard to the present invention in accordance with particular embodiments. It should be noted that the present invention is not limited to such embodiments.

### <Example 1>

A granular resin in the form of pellet was formed by mixing 50 weight part of the molecular sieve 3A and 50 weight part of LDPE (Product Name: Petrothene 204 (manufactured by TOSOH)), as MB1.

A granular resin in the form of pellet was formed by mixing 50 weight part of calcium oxide and 50 weight part of LDPE (Product Name: Petrothene 204 (manufactured by TOSOH)), as MB2.

### (Embodiment 1-1)

A laminated body 1-1 was made by the multilayer inflation method, wherein the inner layer side of the laminated body 1-1 was formed by mixing MB1 and MB2 (100:0) and the outer layer side of the laminated body 1-1 was formed by mixing MB1 and MB2 (0:100) as the resins for the moisture adsorbent layer, and wherein the LLDPE (Product name: Evolue SP2020) was used as the coherent layer. The thickness of the laminated body 1-1 was as outer layer/inner layer/coherent layer=70µm/70µm/20µm.

A polyethylene terephthalate (PET) film (Product Name: E8100 (Toyobo), 25 µm thickness) as the biaxially-stretched film was attached on the coherent layer side of so obtained laminated body 1-1 by the dry lamination method. Further, an adhesion layer was formed by coating the acrylate adhesive agent as the adhesive agent on the biaxially-stretched film side. Then, a detachment film was attached on the adhesion layer, thereby obtaining an adsorbent film 1-1.

### (Embodiment 1-2)

An adsorbent film 1-2 was made in accordance with the embodiment 1-1, except that the ratio of MB1 and MB2 was changed to 20:80.

### (Embodiment 1-3)

An adsorbent film 1-3 was made in accordance with the embodiment 1-1, except that the ratio of MB1 and MB2 was changed to 50:50.

### (Embodiment 1-4)

An adsorbent film 1-4 was made in accordance with the embodiment 1-1, except that the ratio of MB1 and MB2 was changed to 80:20.

### <Example 2>

### (Embodiment 2-1)

An adsorbent film 2-1 was made in accordance with the embodiment 1-1, except that the ratio of MB1 and MB2 in the inner layer side was changed to 80:20.

### (Embodiment 2-2)

An adsorbent film 2-2 was made in accordance with the embodiment 2-1, except that the ratio of MB1 and MB2 in the outer layer side was changed to 20:80.

### (Embodiment 2-3)

An adsorbent film 2-3 was made in accordance with the embodiment 2-1, except that the ratio of MB1 and MB2 in the outer layer side was changed to 50:50.

### <Example 3>

### (Embodiment 3-1)

An adsorbent film 3-1 was made in accordance with the embodiment 1-1, except that the ratio of MB1 and MB2 in the inner layer side was changed to 50:50.

### (Embodiment 3-2)

An adsorbent film 3-2 was made in accordance with the embodiment 3-1, except that the ratio of MB1 and MB2 in the outer layer side was changed to 20:80.

### <Example 4>

### (Embodiment 4-1)

An adsorbent film 4-1 was made in accordance with the embodiment 1-1, except that the ratio of MB1 and MB2 in the inner layer side was changed to 0:100 and the ratio of MB1 and MB2 in the outer layer side was changed to 100: 0.

### <Comparable Example>

### (Comparable Embodiment 1-1 to 1-2)

Comparative films 1-1 and 1-2 were made in accordance with the embodiment 1-1, except that either MB1 or MB2 was used as the resin for the moisture adsorbent layer.

The adsorbent films and comparative films so obtained by the above-mentioned method were cut into having the dimension of 100 mm×100 mm, and then detached the detachment film. These films so obtained were attached to an enclosed space similar to the inside of the organic EL device, thereby obtaining samples. These samples were left to stand in the environment of 25°C temperature/50% relative humidity for 240 hours. Then, moisture adsorbent velocities and amounts of saturated moisture adsorption of the adsorbent films and comparative films were calculated, on the basis of the changes of the weight of these films. In addition, amounts of moisture adsorption of these films in the high-temperature environment (85°C) were also calculated. Further, in order to examine whether acidic materials will be adsorbed in the chemically-adsorptive desiccant as changed into an alkali material by adsorbing the moisture, or not, sheet comprising formaldehyde was disposed in an enclosed space, a heat was applied to vaporize the formaldehyde, and it was examined whether the above-mentioned films will adsorb the formaldehyde or not. A mass spectroscope was used for measuring the present or absence of adsorbing the formaldehyde. The result is shown in Table 1.

**Table 1**

| | Inner layer (part) | | Outer layer (part) | | Velocity of moisture adsorption (25°C /50%RH) (mg/hr) | Amount of saturated moisture adsorption (25°C /50%RH) (mg/100cm²) | Amount of moisture adsorption in the high-temperature (85°C) (mg/100cm²) | Acidic gas (formaldehyde) Presence or Absence of the adsorption |
|---|---|---|---|---|---|---|---|---|
| | MB1 | MB2 | MB1 | MB2 | | | | |
| Embodiment 1-1 | 100 | 0 | 0 | 100 | 3.5 | 155 | 180 | Presence |
| Embodiment 1-2 | 100 | 0 | 20 | 80 | 3.9 | 149 | 173 | Presence |
| Embodiment 1-3 | 100 | 0 | 50 | 50 | 5.1 | 153 | 162 | Presence |
| Embodiment 1-4 | 100 | 0 | 80 | 20 | 5.5 | 154 | 152 | Presence |
| Embodiment 2-1 | 80 | 20 | 0 | 100 | 3.3 | 161 | 187 | Presence |
| Embodiment 2-2 | 80 | 20 | 20 | 80 | 3.4 | 155 | 180 | Presence |
| Embodiment 2-3 | 80 | 20 | 50 | 50 | 4.8 | 146 | 170 | Presence |
| Embodiment 3-1 | 50 | 50 | 0 | 100 | 2.4 | 170 | 198 | Presence |
| Embodiment 3-2 | 50 | 50 | 20 | 80 | 3.1 | 165 | 191 | Presence |
| Embodiment 4-1 | 0 | 100 | 100 | 0 | 5.9 | 156 | 145 | Presence |
| Comp. Embodiment 1-1 | 0 | 100 | 0 | 100 | 1.4 | 186 | 216 | Presence |
| Comp. Embodiment 1-2 | 100 | 0 | 100 | 0 | 6.6 | 146 | 124 | Absence |

As seen from the result shown in Table 1, high moisture adsorbent velocity and the stable moisture adsorption can be obtained in both environments of normal temperature and high-temperature, by means of combining the physically-adsorptive desiccant and chemically-adsorptive desiccant.

As describe above, explanation has been made with regard to the present invention in reference to the preferred embodiments of the present invention. It is obvious that any modifications and alterations can be made without departing from the spirit and scope of the present invention as defined in the claims. That is, the scope of the present invention is not limited to the particular examples and the drawings, and the present invention should be construed only by the claims as attached.

### Industrially applicability

The adsorbent film according to the present invention is applicable to electronics devices, electrical instruments, any food articles, any medications, and the others.

## Claims

1. An adsorbent film being constituted from:
a first moisture adsorbent layer containing a chemically-adsorptive desiccant; and
a second moisture adsorbent layer containing a physically-adsorptive desiccant.

2. The adsorbent film as claimed in claim 1, wherein said physically-adsorptive desiccant is selected from the group consisting of zeolite, silica gel and activated alumina.

3. The adsorbent film as claimed in claim 2, wherein said physically-adsorptive desiccant is zeolite.

4. The adsorbent film as claimed in any one of claims 1 to 3, wherein said chemically-adsorptive desiccant is selected from the group consisting of calcium oxide, calcium chloride, magnesium sulfate, barium oxide, phosphorus pentaoxide, potassium hydroxide, sodium hydroxide, potassium bromide, calcium bromide, copper sulfate, zinc chloride, calcium sulfate and magnesium oxide

5. The adsorbent film as claimed in claim 4, wherein said chemically-adsorptive desiccant is calcium oxide.

6. The adsorbent film as claimed in any one of claims 1 to 5, wherein said chemically-adsorptive desiccant is a material which changes to an alkali matter by absorbing the water.

7. The adsorbent film as claimed in any one of claims 1 to 6, further comprising an adsorptive velocity controlling layer.

8. The adsorbent film as claimed in any one of claims 1 to 7, further comprising an biaxially-stretched film.

9. An organic EL device comprising the adsorbent film as claimed in any one of claims 1 to 8 .

10. The organic EL device as claimed in claim 9, wherein said adsorbent film is constituted such that said second moisture adsorbent layer and said first moisture adsorbent layer are laminated in turn from the wall of said organic EL device.

11. The organic EL device as claimed in claim 10, wherein said first moisture adsorbent layeris constituted only from calcium oxide.

12. The organic EL device as claimed in claim 10 or 11, wherein said second moisture adsorbent layer is constituted only from zeolite, or from zeolite and said chemically-adsorptive desiccant.
